Europäisches Patentamt

(19) European Patent Office

Office européen des brevets

(11) Publication number: **0 065 013**
**B1**

(12) # EUROPEAN PATENT SPECIFICATION

(45) Date of publication of patent specification: **13.03.85**

(51) Int. Cl.⁴: **H 04 B 1/26, H 03 J 5/24**

(21) Application number: **81903065.1**

(22) Date of filing: **12.11.81**

(86) International application number:
**PCT/JP81/00330**

(87) International publication number:
**WO 82/01796 27.05.82 Gazette 82/14**

(54) **TUNER.**

(30) Priority: **14.11.80 JP 163763/80 u**

(43) Date of publication of application:
**24.11.82 Bulletin 82/47**

(45) Publication of the grant of the patent:
**13.03.85 Bulletin 85/11**

(84) Designated Contracting States:
**DE FR GB**

(56) References cited:
**DE-A-2 624 133**
**JP-B-51 043 923**
**JP-B-52 015 492**
**JP-U-55 000 892**
**JP-Y-51 026 582**
**US-A-4 118 679**

**PATENTS ABSTRACTS OF JAPAN, vol. 4, no.
14, January 31, 1980, E-169**

(73) Proprietor: **SANYO ELECTRIC CO., LTD.**
**18, 2 chome, Keihan-Hondori**
**Moriguchi-shi Osaka 570 (JP)**

(72) Inventor: **MIYOSHI, Teijiro**
**29-303, 12-ban, Miigaoka 1-chome Neyagawashi**
**Osaka 572 (JP)**

(74) Representative: **Glawe, Delfs, Moll & Partner**
**Patentanwälte**
**Postfach 26 01 62 Liebherrstrasse 20**
**D-8000 München 26 (DE)**

Courier Press, Leamington Spa, England.

## Description

Field of the Invention

This invention relates to a tuner device which uses a variable capacity diode as a tuning element, and is set selectively in a VHF low-band, a VHF high-band or a UHF band by a one-circuit triple contact switch to whose common contact is given DC supply voltage, and a band-switching diode, which switches tuning coils in a VHF input circuit and is conducting during UHF band reception.

Background of the Invention

Generally, a tuner for a television receiver or the like, employing a variable capacity diode as a tuning element, has a band switching circuitry which selectively switches a VHF low-band, a VHF high-band and a UHF band. Therefore, from the viewpoint of simplifying an electric power source for switching the band, it has been proposed that the one circuit triple contact switch, which applies DC supply voltage selectively to each contact for the VHF low-band, VHF high-band or UHF band to perform the band switching, is used for switching voltage. Such a one-circuit triple-contact switch is known also for VHF, UHF, and superband tuner with automatic switching to be used in connection with cable television (US—A 4 118 679).

The band switching mechanism in the conventional tuner for VHF low-band, VHF high-band and UHF band using the one-circuit triple-contact switch, however, has a switching diode at a VHF tuner kept in not-biased condition when UHF is received, so that a VHF signal at high level given to a VHF input terminal, especially the nonlinearity of the switching diode in a VHF input tuning circuit, generates a harmonic frequency identical with the UHF band, resulting in that the harmonic wave is given into the input side at the UHF tuner unit to appear as noise in the picture. Such a phenomenon is noticeable when the VHF tuner unit and UHF tuner unit are encased in the same casing or the UHF and VHF signals from the antenna are divided by a frequency divider to be led to the VHF input terminal and UHF input terminal respectively. The reason for the former case is that the harmonic wave can easily jump from the periphery of the switching diode to the input side of the UHF tuner unit in the casing, and that for the latter case is that the harmonic wave generated by the switching diode enters the UHF input terminal from the VHF input terminal through an external frequency divider. Hence, a tuner having both the above constructions in combination is more susceptible to the above trouble.

The problems arising when harmonic waves are generated can be solved at least partly in a tuner device of the type mentioned above in which the band-switching diode is kept conducting during UHF band reception (JP—A—54 154 922). Due to the fact, however, that a diode is a non-linear device, it cannot be completely avoided that harmonics are generated.

Summary of the Invention

In the light of the above problems in the conventional tuner, this invention has been designed. The object of the invention is to provide a tuner of the above mentioned type of simple construction in which possible noise due to harmonic waves generated at the VHF input circuit is further reduced.

In order to attain the above object the tuner device of the above mentioned type is characterized in that two contacts of the one-circuit triple contact switch, one of them corresponding to a VHF high-band and the other corresponding to a UHF band, are connected to the connection point between one terminal of the band-switching diode and a high frequency grounding condenser respectively via other switching diodes and in that the other terminal of said band-switching diode is connected to said tuning coils and further connected to resistors of a bias circuit for an RF amplifying transistor in the VHF input circuit so that DC current which enables said band-switching diode to be conducting flows to the earth through said resistors.

Contrary to the previously known tuner (JP—A—54 194 922) the band-switching diode is grounded directly by connection to the earth via the high frequency grounding condenser, whereas in case of the previously known tuner the band-switching diode is connected with the high frequency grounding condenser only indirectly via high frequency coils. At UHF reception harmonics will almost not arise due to the conduction of the switching diode. Harmonics which arise nevertheless during conduction of the band-switching diode flow into earth through the high frequency grounding condenser. Thus in the tuner device of the invention harmonics are perfectly eliminated contrary to the case of the previously known tuner where the switching diode is not directly connected to the high frequency grounding condenser.

The inventive tuner in addition is of simple construction because the current path for making the band-switching diode conductive also includes resistors for biasing the RF amplifying transistor. Therefore, no complicated additional circuits have to be provided for switching the diode in the intended manner.

In the tuner device of the invention a supply voltage is applied to a common contact at the one-circuit triple-contact switch, the common contact connecting the compound-circuit. A first contact of the switch is connected to turn on a local oscillator and a radio frequency amplifying transistor in the VHF tuner unit, a second contact of the switch is connected to actuate tuning coil switching diodes and a radio frequency amplifying transistor and a local oscillator in an interstage tuning circuit of the VHF tuner unit, and connected to apply conducting voltage for a first switching diode through a second switching diode to the node of the first switching diode turned on to void a coil for a low band at the VHF input tuning circuit and a high-frequency grounding condenser, and a third contact of the switch is connected to a UHF tuner unit and also connected through a third switching diode to the node of the first switching diode and a high-frequency grounding condenser, thereby turning on the first switching diode when receiving the UHF band.

In the tuner having the band switching mechanism employing the one-circuit triple-contact switch as foregoing, the tuning coil switching diode in the VHF input tuning circuit is turned on without being not-biased while receiving the UHF band.

Furthermore, the first switching diode for switching the tuning coil at the VHF input tuning circuit, when the UHF band is received, as abovementioned, is turned on by being given supply voltage from the third contact of the switch through the third switching diode. Hence, when the band other than the UHF band is received, the input tuning circuit and the third contact side are cut off by the third switching diode not to affect the UHF tuner unit. When the VHF high-band is received, the first switching diode is given drive voltage therefor from the second contact through the second switching diode, whereby when the UHF band is received, the input tuning circuit and the second contact are cut off by the second switching diode, thus not affecting the RF amplifier and local oscillator. Moreover, in the input tuning circuit, the second and third switching diodes are both connected to the high-frequency grounding condensers, so that both the diodes, even when turned off, will produce no harmonic wave.

These and other objects of the invention will become more apparent in the detailed description and examples which follow.

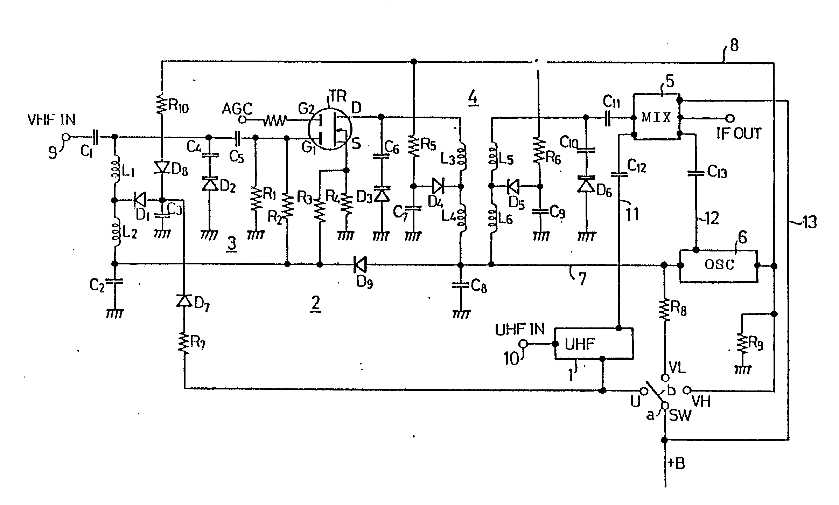

Brief Description of the Drawing

The drawing is a circuit diagram of an embodiment of a tuner of the invention.

Detailed Description of the Preferred Embodiment

This invention will be detailed concretely in accordance with the accompanying drawing, in which reference SW denotes a one-circuit triple-contact switch having a movable part b connected to a common contact a and capable of connecting selectively with a first contact VL, a second contact VH, and a third contact U. Alternatively, any switch employing transistors or diode elements to be formed in an electronic circuitry manner, other than the above switch having the mechanically movable part b, may of course be available, so that the one-circuit triple-contact switch described herewith will include such electronically acting switch.

Reference numeral 1 denotes a UHF tuner unit given a UHF signal from an input terminal 10, and 2 denotes a VHF tuner unit except for the switch SW portion, both the tuner units being encased within the same box-like casing through a printed substrate. An internal construction of UHF tuner unit 1 is not concretely shown, but the VHF tuner unit 2 is shown in detail of an input tuning circuit 3 and an interstage tuning circuit 4 and in block of a mixer circuit 5 and a local oscillator 6. References $D_2$, $D_3$ and $D_6$ denote variable capacity diodes, where tuning voltage supply lines thereto are omitted, TR denotes a radio frequency (RF) amplifying transistor, in which a first gate $G_1$ is given a RF signal selected by the input tuning circuit 3, and a second gate $G_2$ is given auto-frequency control voltage from a terminal AGC, $L_1$, $L_3$ and $L_5$ denote tuning coils for the VHF high-band, $L_2$, $L_4$ and $L_6$ denote tuning coils acting together with the coils $L_1$, $L_3$ and $L_5$ when VHF low-band is received, $D_1$, $D_4$ and $D_5$ denote switching diodes for switching the tuning coils, and $C_1$ to $C_{13}$ denote condensers for DC cut-off and almost negligible of impedance with respect to the signals given to the condensers respectively.

The first contact VL at the one-circuit triple-contact switch SW is connected to the local oscillator 6 and the line 7. The line 7 is connected to the node of a condenser $C_8$ and the cold sides of tuning coils $L_4$ and $L_6$ and further to the node of bias resistances $R_2$ and $R_3$ of the RF transistor, tuning coil $L_2$ and condenser $C_2$, through a fourth switching diode $D_9$ interposed in porality as shown.

The second contact VH of the switch SW is connected to one end of each of the resistances $R_9$ and $R_{10}$, the other end of resistance $R_9$ being grounded and the other end of resistance $R_{10}$ being connected to the anode of a second switching diode 8, the cathode thereof being connected to the node of the first switching diode $D_1$ and high-frequency grounding condenser $C_3$. Also, the second contact VH is connected to resistances $R_5$ and $R_6$ through the line 8 as shown.

The third contact U of switch SW is connected to the UHF tuner unit 1 and to the node of the first switching diode $D_1$ and second switching diode $D_8$ through a current limiting resistance $R_7$ and third switching diode $D_7$. The output line 11 of UHF tuner unit 1 is connected to the mixer circuit 5 through a coupling condenser $C_{12}$ and the output line 12 of local oscillator 6 is connected also to the mixer circuit 5 through a coupling condenser $C_{13}$.

The common contact a of switch SW is given DC supply voltage (+B), which is fed always to the mixer circuit 5 via the line 13 to thereby keep the mixer circuit 5 in an actuated condition regardless of the band switching, which purposes allowing the mixer circuit 5 to operate as an amplifier for an intermediate frequency (IF) output of UHF tuner when receiving the UHF band.

In the abovementioned tuner, when the movable part b at the one-circuit triple-contact switch SW connects with the first contact VL, the drain D of RF amplifying transistor TR is given the supply voltage (+B) through the line 7 and the tuning coils $L_4$ and $L_3$ and the first gate $G_1$ and source S

of transistor TR are under bias by a current flowing through the fourth switching diode $D_9$ and resistances $R_2$ and $R_1$ and those $R_3$ and $R_4$, whereby the RF amplifying transistor TR is actuated, at which time the switching diodes $D_1$, $D_8$, $D_4$ and $D_5$ are under inverted bias not to be conductive. The local oscillator 6 also is given the supply voltage (+B) through a resistance $R_8$ and actuated to feed its local oscillation signal to the mixer circuit 5, at which time the oscillator 6 is adapted to be set in the low band state by the supply voltage (+B) given from the first contact VL. The mixer circuit 5 outputs from its IF output terminal IFOUT an intermediate frequency signal generated by the beat caused by the RF signal of the VHF low band given from the VHF input terminal 9 through the input tuning circuit 3, RF amplifying transistor TR and interstage tuning circuit 4 and by the local oscillation signal from the local oscillator 6.

Next, when the movable part b connects with the second contact VH of one-circuit triple-contact switch SW, the local oscillator 6 is given the operating voltage (+B) through the line 8, the voltage setting the local oscillator 6 in the high-band stage.

Further, the drain of RF amplifying transistor TR is given voltage from the line 8 via resistance 5, switching diode $D_4$ and tuning coil $L_3$, and a current flows from the line 8 to the switching diode $D_8 \rightarrow$ that $D_1 \rightarrow$ tuning coil $L_2 \rightarrow$ resistances $R_2$, $R_3 \rightarrow$ resistances $R_1$, $R_4$ and from the line 8 to the resistance $R_5 \rightarrow$ switching diode $D_4 \rightarrow$ tuning coil $L_4 \rightarrow$ 4th switching diode $D_9 \rightarrow$ resistances $R_2$, $R_3 \rightarrow$ resistances $R_1$, $R_4$ and from the line 8 to the resistance $R_6 \rightarrow$ switching diode $D_5 \rightarrow$ tuning coil $L_6 \rightarrow$ 4th switching diode $D_9 \rightarrow$ resistances $R_2$, $R_3 \rightarrow$ resistances $R_1$, $R_4$, whereby the RF amplifying transistor TR is given bias at its first gate $G_1$ and source S so as to be put in the actuated condition, at which time the switching diodes $D_1$, $D_4$ and $D_5$ are on to put the tuning coils $L_2$, $L_4$ and $L_6$ in an inactive condition in connection with the high frequency through the condensers $C_3$, $C_7$ and $C_9$, whereby the tuner is kept in the state of receiving the VHF high-band.

Next, when the movable part b connects with the third contact U of one-circuit triple-contact switch SW, the UHF tuner unit 1 is given the operating voltage (+B) to be actuated and a current flows through the third switching diode $D_7 \rightarrow$ first switching diode $D_1 \rightarrow$ tuning coil $L_2 \rightarrow$ resistances $R_2$, $R_3 \rightarrow$ resistances $R_1$, $R_4$ to thereby turn on the first switching diode $D_1$. In such state that the first switching diode $D_1$ is under bias in the forward direction so as to be conductive, even when the VHF signal is given, the switching diode $D_1$ scarcely generates the harmonic wave. In addition, the second switching diode $D_8$ and fourth switching diode $D_9$ interrupt the drain of RF amplifying transistor TR and the local oscillator 6 from being given the operating voltage, while the third switching diode $D_7$ serves to interrupt the UHF tuner unit 1 from being given the operating voltage when the VHF high-band is received.

In the drawing, a conducting current for the switching diode $D_1$, when receiving the UHF, flows to the earth through the tuning coil $L_2$, resistances $R_2$, $R_1$ and resistances $R_3$, $R_4$ to apply bias between the first gate $G_1$ and the source S of amplifying transistor TR, but the drain thereof is not under bias due to the cutoff of the fourth switching diode $D_9$, thereby keeping the amplifying transistor TR in off-condition. The bias resistance of amplifying transistor TR is used as the return circuit for the conducting current for the switching diode $D_1$, alternatively the fourth switching diode $D_9$ may be interposed on the line connecting the tuning coil $L_2$ and resistance $R_2$ and a return circuit resistance may be interposed between the cathode of diode $D_9$ and the earth to thereby flow the current to the earth through the return circuit resistance.

When the movable contact b connects with the first contact VL at the one-circuit triple-contact switch SW to receive the VHF low-band, the fourth switching diode $D_9$ is biased in the forward direction, but the switching diodes $D_1$, $D_4$, $D_5$, $D_7$ and $D_8$ are all biased in the backward directions. In case that the switching diodes $D_1$, $D_7$ and $D_8$ are extremely different in the inverted impedance, there is the probability that the diode $D_1$ is not sufficiently biased in the backward direction. In such case, each of diodes $D_1$ and $D_7$ or $D_1$ and $D_8$ is connected in parallel to a high resistance, so that the anode potential of $D_1$ need only be decided.

While the invention has been described in the preferred embodiment, it is to be understood that the scope of this invention is of course not limited to the above embodiment but is defined in the following claims.

**Claims**

1. A tuner device which uses a variable capacity diode ($D_2$) as a tuning element, and is set selectively in a VHF low-band, a VHF high-band or a UHF band by a one-circuit triple contact switch (SW) to whose common contact (b) is given a DC supply voltage (+B), and a band-switching diode ($D_1$), which switches tuning coils ($L_1$, $L_2$) in a VHF input circuit (3) and is conducting during UHF band reception characterized in that two contacts (VH, U) of the one-circuit triple contact switch (SW), one (VH) of them corresponding to a VHF high-band and the other (U) corresponding to a UHF band, are connected to the connection point between one terminal of the band-switching diode ($D_1$) and a high frequency grounding condenser ($C_3$) respectively via other switching diodes ($D_7$, $D_8$), and in that the other terminal of said band-switching diode ($D_1$) is connected to said tuning coils ($L_1$, $L_2$) and further connected to resistors ($R_1$—$R_4$) of a bias circuit for an RF amplifying transistor (TR) in the VHF input circuit (3) so that DC current which enables said band-switching diode ($D_1$) to be conducting flows to earth through said resistors (R₁—R₄).

2. A tuner device as claimed in claim 1, characterized in that it comprises further band-switching diodes (D₄, D₅) which switch further tuning coils (L₃, L₄; L₅, L₆) in subsequent tuning stages (4).

3. A tuner device as claimed in claim 2, characterized in that the further band-switching diodes (D₄, D₅) are directly connected to high frequency grounding condensers (C₇, C₈).

4. A tuner device as claimed in any of claims 1—3, characterized in that the RF amplifying transistor (TR) is active only when the one-circuit triple contact switch (SW) is switched for reception of the VHF low-band or high-band.

## Patentansprüche

1. Kanalwähler mit einer variablen Kapazitätsdiode (D₂) als Abstimmelement, welcher wahlweise auf ein unteres VHS-Band, ein oberes VHS-Band oder ein UHS-Band eingestellt werden kann durch einen Einfach-Dreiwegeschalter (SW), an dessen gemeinsamen Kontakt (b) eine Versorgungsgleichspannung (+D) angelegt wird und durch eine Bandumschaltdiode (D₁) welche Abstimmspulen (L₁, L₂) im VHS-Eingangsschaltkreis (3) schaltet und beim UHS-Bandempfang leitend ist, dadurch gekennzeichnet, daß zwei Kontakte (VHU) des Einfach-Dreiwegeschalters (SW), von denen der eine (VH) dem oberen VHF-Band und der andere (U) dem UHS-Band entsprechen, mit einem Verbindungspunkt zwischen einem Anschluß der Bandschaltdiode (D₁) und einem Hochfrequenz-Masse-Kondensator (C₃) über andere Schaltdioden (D₇ bzw. D₈) verbunden sind, und daß dann der Anschluß der Bandschaltdiode (D₁) mit den Abstimmspulen (L₁, L₂) verbunden ist und außerdem mit Widerständen (R₁—R₆) eines Vorspannschaltkreises für einen RF-Verstärkertransister (TR) im VHF-Eingangsschaltkreis (3), so daß ein Gleichstrom, welcher die Bandschaltdiode (D₁) leitfähig macht, über die Widerstände (R₁—R₄) zur Erde fließt.

2. Kanalwähler nach Anspruch 1, dadurch gekennzeichnet, daß er ferner Bandschaltdioden (D₄, D₅) aufweist, die weitere Abstimmspulen (L₃, L₄, L₅, L₆) in darauf folgenden Abstimmstufen (4) schalten.

3. Kanalwähler nach Anspruch 2, dadurch gekennzeichnet, daß die weiteren Bandschaltdioden (D₄, D₅) direkt mit Hochfrequenz-Masse-Kondensatoren (C₇, C₉) verbunden sind.

4. Kanalwähler nach einem der Ansprüche 1 bis 3, dadurch gekennzeichnet, daß der RF-Verstärkertransistor (TR) nur dann in Betrieb ist, wenn der Einfach-Dreiwegeschalter (SW) für den Empfang des oberen oder unteren VHF-Bandes geschaltet ist.

## Revendications

1. Dispositif syntonisateur qui utilise une diode à capacité variable (D₂) comme élément de syntonisation et qui est réglé sélectivement dans une gamme basse VHF, une gamme haute VHF ou une gamme UHF par un commutateur à triple contact à un circuit (SW), au contact commun (B) duquel est appliquée une tension d'alimentation continue (+B), et par une diode de commutation de gammes (D₁) qui commute des bobines d'accord (L₁, L₂) dans un circuit d'entrée VHF (3) et qui est conductrice pendant la réception dans la gamme UHF, caractérisé en ce que deux contacts (VH, U) du commutateur à triple contact à un circuit (SW), dont l'un (VH) correspond à une haute gamme VHF et l'autre (U) correspond à une gamme UHF, sont reliés au point de jonction entre l'une des bornes de la diode de commutation de gammes (D₁) et un condensateur de mise à la terre à haute fréquence (C₃), respectivement par l'intermédiaire d'autres diodes de commutation (D₇, D₈), et en ce que l'autre borne de la diode de commutation de gammes (D₁) est raccordée aux bobines d'accord (L₁, L₂) et est en outre raccordée à des résistances (R₁ à R₄) d'un circuit de polarisation pour un transistor amplificateur H.F. (TR) dans le circuit d'entrée VHF (3), de telle manière que le courant continu qui permet à la diode de commutation de gammes (D₁) d'être conductrice s'écoule vers la terre à travers ces résistances (R₁ à R₄).

2. Dispositif syntonisateur selon la revendication 1, caractérisé en ce qu'il comprend des diodes supplémentaires de commutation de gammes (D₄, D₅) qui commutent des bobines d'accord supplémentaires (L₃, L₄; L₅, L₆) dans des étages de syntonisation subséquents (4).

3. Dispositif syntonisateur selon la revendication 2, caractérisé en ce que les diodes supplémentaires de commutation de gammes (D₄, D₅) sont raccordées directement à des condensateurs de mise à la terre à haute fréquence (C₇, C₉).

4. Dispositif syntonisateur selon l'une quelconque des revendications 1 à 3, caractérisé en ce que le transistor amplificateur H.F. (TR) n'est actif que quand le commutateur à triple contact à un circuit (SW) est commuté en position de réception de la gamme basse ou de la gamme haute VHF.